Europäisches Patentamt

(19) **European Patent Office**

Office européen des brevets

(11) Numéro de publication: **0 012 689**
**B1**

(12) **FASCICULE DE BREVET EUROPEEN**

(45) Date de publication du fascicule du brevet:
14.07.82

(51) Int. Cl.³: **H 03 H 9/05**

(21) Numéro de dépôt: 79400999.3

(22) Date de dépôt. 11.12.79

(54) Résonateur piézoélectrique à tiroir.

(30) Priorité· 19.12.78 FR 7835631

(43) Date de publication de la demande:
25.06.80 Bulletin 80/13

(45) Mention de la délivrance du brevet.
14.07.82 Bulletin 82/28

(84) Etats contractants désignés:
DE GB SE

(56) Documents cités:
**FR-A-2 338 607**
**GB-A-447 665**
**US-A-2 418 491**
**US-A-2 597 797**

(73) Titulaire: **ETAT-FRANCAIS représenté par le DELEGUE GENERAL POUR L'ARMEMENT, Bureau des Brevets et Inventions de la Délégation Générale pour l'Armement 14, rue Saint-Dominique, F-75997 Paris Armées (FR)**

(72) Inventeur· **Besson, Raymond, 22, rue Octave Davis, F-25000 Besancon (FR)**
Inventeur: **Maitre, Pierre, rue des Cryots, F-25480 Pirey (FR)**

Résonateur piézoélectrique à tiroir

La présente invention a pour objet un résonateur piézoélectrique dit »à tiroir« du type à électrodes non adhérentes au cristal et comprenant un boitier étanche dans lequel on a fait le vide, ou introduit un gaz résiduel, à l'intérieur de ce boitier, au moins un cristal piézoélectrique muni d'une partie périphérique formant bague reliée à une partie centrale par une zone intermédiaire qui présente une faible longueur dans le sens radial, des electrodes disposées respectivement en regard de chacune des faces de la partie centrale du cristal, à faible distance de celles-ci, et des moyens de maintien des électrodes et du cristal dans des positions relatives prédéterminées à l'intérieur du boitier.

Dans des résonateurs piézoélectriques connus à électrodes non adhérentes au cristal, tels que ceux décrits dans la demande de brevet français n° 2 338 607, les électrodes sont déposées par métallisation sur des plateaux ou disques en matériau diélectrique entre lesquels est interposée une pastille de cristal piézoélectrique. L'espacement entre les deux plateaux-support d'électrode, et par suite la distance entre les électrodes et les faces de la partie active du cristal disposée en regard des électrodes, est déterminée par une partie périphérique de la pastille piézoélectrique qui joue le rôle de bague entretoise et est interposée entre les deux plateaux. La réalisation de sufaces complémentaires sur la bague entretoise et sur les parties correspondantes des plateaux diélectriques qui coopèrent avec la bague entretoise permettent de réaliser des intervalles entre électrode et cristal qui sont très faibles et très précis, tout en garantissant que le cristal ne vienne en aucun cas toucher les électrodes. Un tel dispositif est d'un reglage relativement commode mais implique la présence d'au moins trois pièces distinctes, à savoir deux plateaux diélectriques et une pastille piézoélectrique. Ces trois pièces sont maintenues assemblées par des moyens de maintien tels que des vis ou des ressorts qui autorisent une amovibilité de ces pièces et permettent par exemple de retirer la pastille piézoélectrique pour modifier ses caractéristiques géométriques, puis de la réintroduire entre les plateaux diélectriques pour former un resonateur présentant de nouvelles caractéristiques, telles qu'une fréquence de résonance modifiée. Le système précité présente toutefois certains inconvénients. Ainsi, le cristal piézoélectrique ne peut pas être retiré puis réinséré entre les plateaux sans déplacement de ces derniers. Par ailleurs, la présence de trois éléments distincts rend le montage relativement délicat dans la mesure où les moyens de maintien doivent être prévus pour retenir les trois éléments dans des positions relatives bien déterminées les unes par rapport aux autres.

La présente invention vise précisément à remédier aux inconvénients précités et à réaliser un résonateur dont la fabrication et le montage sont simplifiés tandis que les qualités de précision dans la détermination des caractéristiques du résonateur sont sauvegardées.

Ces buts sont atteints grâce à un résonateur piézoélectrique à électrodes non adhérentes du type mentionné au début dans lequel, conformément à l'invention, les moyens de maintien des électrodes et du cristal comprennent un bloc unitaire en matériau diélectrique dans lequel est ménagée au moins une ouverture qui présente une section supérieure à la section du cristal pour permettre une insertion du cristal à travers ladite ouverture, les électrodes sont déposées sur le bloc diélectrique dans la partie centrale respectivement des faces supérieure et inférieure de l'ouverture et le cristal est immobilise dans ladite ouverture par sa partie périphérique de manière que la partie centrale du cristal reste située en regard des électrodes et sans contact avec celles-ci.

De préférence, le cristal piézoélectrique repose par des portions de sa partie périphérique directement sur la face inférieure de l'ouverture du bloc diélectrique dans des zones de ladite face inférieure qui sont adaptées à la forme de la partie périphérique du cristal.

Dans ce cas, des moyens mécaniques de serrage coopèrent avec la partie périphérique du cristal pour maintenir des portions de cette partie périphérique en contact avec les dites zones de la face inférieure de l'ouverture du bloc diélectrique.

De manière avantageuse, les moyens mécaniques de serrage sont constitués par des moyens de maintien élastiques tels que des ressorts.

Grâce à la présente invention, le montage d'un cristal piézoélectrique entre les électrodes peut être réalisé d'une manière particulièrement commode. En effet, le cristal peut être inséré dans l'ouverture du bloc piézoélectrique à la manière d'un tiroir, par simple coulissement, sans que la position du bloc piézoélectrique soit modifiée. Ainsi, non seulement les électrodes sont déposées sur un support unique, mais encore la mise en place de la pastille de quartz entre les électrodes est facilitée. La distance entre les électrodes et les faces de la partie active du cristal de quartz est déterminée par l'épaisseur de la partie périphérique du cristal qui coopère directement ou indirectement avec les parties périphériques des faces supérieure et inférieure de l'ouverture du bloc diélectrique. L'ajustement des espaces libres entre électrode et cristal est rendu plus aisé si la partie périphérique du cristal coopère directement avec une seule face, par exemple la face inférieure de l'ouverture du bloc diélectrique, tandis que les moyens de maintien agissent directement sur ladite partie périphérique pour maintenir celle-ci en contact avec ladite face inférieure de l'ouverture du bloc diélectrique.

Selon un mode particulier de réalisation la partie périphérique de la face inférieure de l'ouverture du bloc diélectrique est proéminente par rapport à la partie centrale de ladite face inférieure sur laquelle est déposée une électrode.

Divers moyens de maintien du cristal en position peuvent être envisagés. A titre d'exemple, les moyens de serrage sont constitués par des pointeaux engagés et coulissant chacun dans un orifice ménagé dans la partie supérieure du bloc diélectrique, chaque pointeau coopérant avec un moyen de ressort pour exercer une pression sur la partie périphérique du cristal et maintenir celleci en contact avec une zone périphérique de la face inférieure de l'ouverture du bloc diélectrique.

La présente invention se prête particulièrement bien à la réalisation de résonateurs multiples compacts. En effet, il est possible de réaliser dans un bloc diélectrique unique plusieurs ouvertures superposées munies d'électrodes et équipées chacune d'un cristal piézoélectrique.

D'autres caractéristiques et avantages de l'invention ressortiront mieux de la description qui fait suite de modes particuliers de réalisation donnés uniquement à titre d'exemples non limitatifs en référence aux dessins annexés, sur lesquels:

— la figure 1 est une vue de face d'un exemple de résonateur selon l'invention, dans lequel le capot du boitier a été représenté en pointillés,

— la figure 2 est une vue de dessus du résonateur de la figure 1, dans lequel le boitier a été enlevé,

— la figure 3 est une vue de côté selon la flèche F de la figure 1,

— la figure 4 est une vue d'une partie d'une variante de réalisation du résonateur de la figure 1, en coupe parallèle au plan de la figure 1,

— la figure 5 est une vue d'une partie d'un résonateur multiple selon l'invention,

— les figures 6 et 7 sont des vues partielles en coupe selon la ligne J-J de la figure 2 montrant des variantes de réalisation d'un résonateur selon l'invention,

— et la figure 8 est une section selon la ligne VIII-VIII de la figure 1.

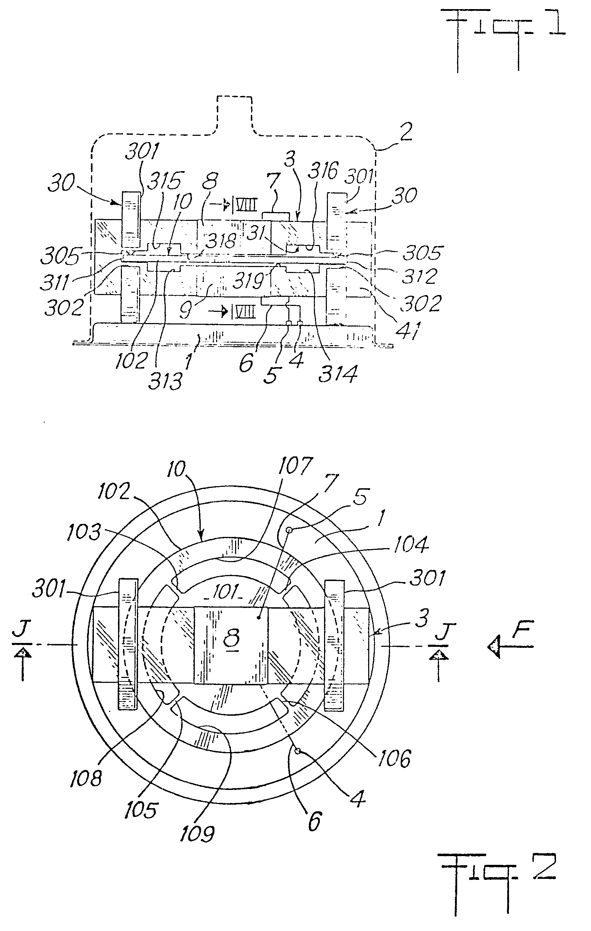

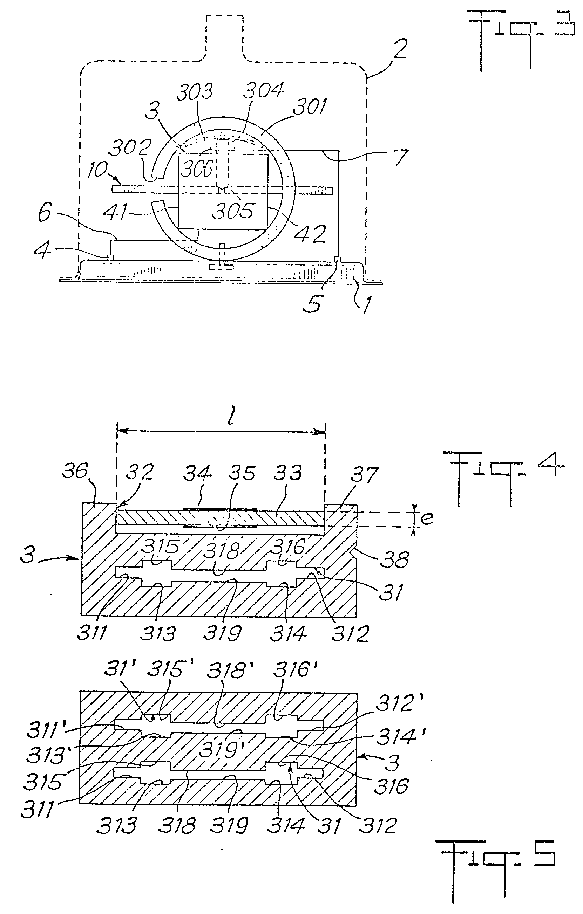

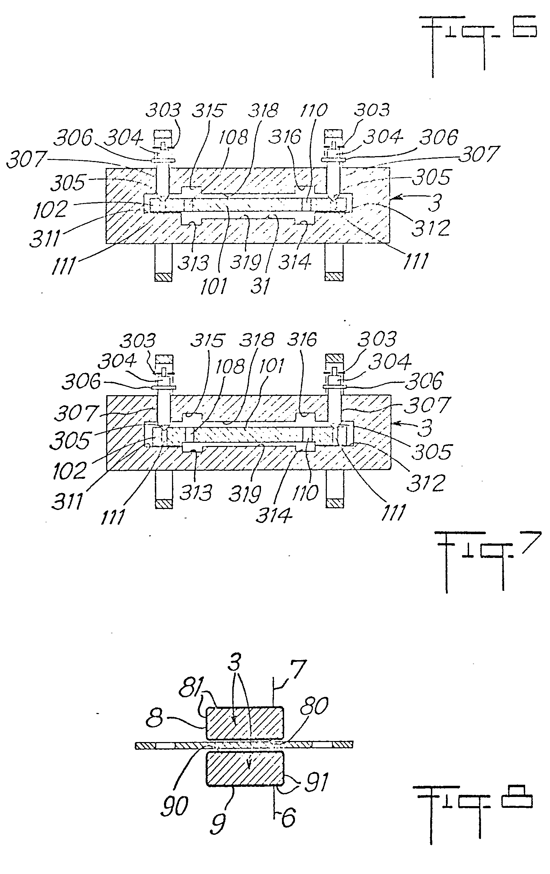

Si l'on se reporte aux figures 1 à 3, on voit un exemple de résonateur conforme à l'invention comprenant un socle 1 sur lequel peut être fixé de façon étanche un capot 2. Le socle 1 et le capot 2 constituent un boitier à l'intérieur duquel on peut, de façon classique réaliser le vide ou introduire un gaz résiduel.

Un bloc diélectrique 3 supporté par des moyens de maintien 30 fixés sur le socle 1 porte des électrodes 8 et 9 reliées respectinement par des fils de liaison 6, 7 à des bornes isolantes 4, 5 pour permettre l'application sur les électrodes d'une tension électrique fournie par une source extérieure au résonateur. Un cristal piézoélectrique 10 est inséré dans une ouverture 31 formée dans le bloc diélectrique 3 supportant les électrodes 8, 9. Le cristal 10 comprend une partie centrale active 101 disposée en regard des parties 80 et 90 des électrodes 8 et 9 déposées respectivement sur les faces supérieure et inférieure de l'ouverture 31 ménagée dans le bloc 3, et une partie périphérique 102 qui assure le maintien en position de la partie centrale active 101 et coopère avec les extrémités latérales 311, 312 de l'ouverture 31 en forme de fente. Le cristal 10 peut facilement être engagé dans la fente 31 à la manière d'un tiroir. Selon le mode de réalisation représenté sur les figures 1 et 2, le cristal 10 est biplan et présente une épaisseur uniforme dans sa partie centrale 101 et sa partie périphérique 102, de même d'ailleurs qu'au niveau des étroits ponts de liaison 103 à 106 qui relient la partie périphérique 102 à la partie centrale 101 et font partie d'une zone intermédiaire du cristal qui est de faible longueur dans le sens radial du cristal et se trouve en majeure partie évidée, au niveau des zones 106 à 109. A titre de variante, les ponts 103 à 106 pourraient être moins étroits mais amincis par rapport à l'épaisseur des parties centrale 101 et périphérique 102. Le nombre, la forme et l'emplacement des ponts 103 à 106 dans la zone intermédiaire du cristal 10 peuvent naturellement varier en fonction des applications.

Selon le mode de réalisation représenté sur les figures 1 à 3, le cristal piézoélectrique 10 est en forme de disque tandis que le bloc diélectrique 3 supportant les électrodes et le cristal est de forme parallélépipédique. Ainsi, le cristal conserve tous les avantages des pièces de révolution tandis que le bloc diélectrique est lui-même très simple à fabriquer.

L'ouverture 31 en forme de fente ménagée dans le bloc 3 traverse ce dernier de part en part et présente de préférence des faces planes et parallèles. Toutefois, l'ouverture 31 est avantageusement de hauteur non constante. Diverses formes d'ouverture 31 peuvent être réalisées facilement. En effet, l'ouverture 31 peut être formée par usinage ultrasonique, ce qui autorise une grande précision dans la géométrie et les dimensions de cette ouverture 31. Sur la figure 1, on peut distinguer une ouverture 31 qui est en tout point de hauteur au moins légèrement supérieure à l'épaisseur du cristal 10, et dont la largeur est également légèrement supérieure au diamètre de la pastille de cristal 10. L'ouverture 31 possède non seulement des faces supérieure et inférieure horinzontales planes et parallèles mais également des faces latérales verticales parallèles entre elles et perpendiculaires aux faces frontales 41, 42 du bloc 3.

L'ouverture représentée sur la figure 1 comprend deux portions latérales d'extrémité 311 et 312 qui coopèrent avec des portions de la partie périphérique 102 du cristal 10. Les parties centrales 318 et 319 respectivement des faces supérieure et inférieure de l'ouverture 31 portent des parties d'électrode 80 et 90 destinées à créer un champ électrique excitateur pour la partie centrale active 101 du cristal. Les parties d'électrode 80 et 90 peuvent être par exemple de forme carrée et sont déposées par métallisation sur les faces 318, 319 de l'ouverture 31, le bloc 3 étant lui-même de préférence disposé de telle sorte que l'ouverture 31 se trouve sensiblement verticale lors de l'opération de métallisation.

L'ouverture 31 présente une hauteur plus importante au voisinage de la zone intermédiaire partiellement évidée du cristal 10. Les retraits 313, 314 ainsi formés dans le bloc diélectrique 3 facilitent pour l'ouverture 31 la formation de faces supérieure et inférieure ayant des niveaux différents dans leur partie centrale 318, 319 portant les parties d'électrode 80, 90 et au niveau des extrémités latérales 311 et 312 qui coopèrent avec des portions de la partie périphérique 102 du cristal.

La forme de l'ouverture 31 et celle de la pastille de cristal 10 permettent de réaliser des espaces libres d'épaisseur prédéterminée entre les électrodes 8, 9 et les faces correspondantes de la partie centrale active 101 du cristal. La dimension de ces espaces libres est capitale puisqu'elle détermine la fréquence de résonance du résonateur. Le dispositif selon l'invention permet de réaliser des espaces libres entre électrode et cristal d'une hauteur inférieure à quelques microns et même à quelques dixièmes de microns.

Dans le mode de réalisation de la figure 1, des portions de la partie périphérique 102 du cristal 10 portent directement, au niveau des portions d'extrémités latérales 311 et 312 de l'ouverture 31, sur des portions de la face inférieure de l'ouverture 31 qui sont proéminentes par rapport à la partie cenrale 319 de la face inférieure qui supporte l'électrode 9. La surface inférieure de la partie périphérique 102 du cristal et les parties proéminentes de la face inférieure de l'ouverture 31 dans les zones 311 et 312 sont des surfaces prévues pour se correspondre parfaitement et assurer, lorsqu'elles sont en contact, un positionnement précis du cristal par rapport aux faces 318 et 319 porteuses d'électrodes.

Des moyens de maintien 30 sont prévus pour maintenir en position le bloc 3 à l'intérieur du boitier 1,2 et assurer également un verrouillage de la position du cristal 10 à l'intérieur de l'ouverture 31. Les moyens de maintien 30 comprennent, selon l'exemple des figures 1 à 3, deux arceaux 301 fixés sur le socle 1. Le bloc 3 repose directement sur la partie inférieure des arceaux 301. Les arceaux 301 sont interroumpus dans leur partie avant pour former une fente 302 permettant le passage du cristal 10 qui doit être inséré dans l'ouverture 31 du bloc 3. Les arceaux sont disposés au voisinage des portions latérales d'extrémité 311, 312 de l'ouverture 31. De la sorte, des moyens mécaniques complémentaires de serrage peuvent coopérer à la fois avec les arceaux 301 et la partie périphérique 102 du cristal pour maintenir en position le cristal 10 par rapport au bloc 3. Ces moyens mécaniques de serrage comprennent une tige 304 terminée à son extrémité inférieure par un pointeau 305 et fixée à son extrémité supérieure à une lame-ressort 303 coopérant avec l'arceau 301. Une rondelle 306 solidaire de la tige 304 assure en outre le maintien du bloc 3 contre la partie inférieure d'un arceau 301 lorsqu'aucun cristal n'est engagé dans la fente 31. Les tigespointeaux 304, 305 se déplacent dans des orifices 307 ménagés dans la partie supérieure du bloc 3 et le pointeau 305 vient s'appliquer, par l'action du ressort 303, sur la partie périphérique 102 du cristal 10. De petits trous 111 formés dans la partie périphérique 102, de préférence en des zones éloignées des ponts de liaison 103 à 106, peuvent recevoir les pointeaux 305 et assurer un verrouillage de la position du cristal 10 par rapport au bloc 3. Sous l'action des moyens élastiques de serrage 303 à 305, la partie périphérique 102 du cristal 10 est maintenue appliquée en contact intime avec les portions de la face inférieure de l'ouverture 31 situées au voisinage des extrémités latérales de ladite ouverture, et le cristal 10 ne peut pas non plus se déplacer intempestivement parallèlement à son plan puisqu'il est maintenu bloqué par les pointeaux 305 engagés partiellement dans les orifices 111. Les contraintes exercées par les pointeaux 305 n'affectent pas la qualité du résonateur puisque la zone intermédiaire du cristal assure, de façon connue en soi, une isolation de la partie centrale active et vibrante par rapport à la partie périphérique immobilisée. Par ailleurs, si les points d'action 111 des efforts des pointeaux 305 sont situés à une distance appréciable des ponts de liaison 103 à 106, la répercussion sur la partie centrale 101 est quasi-nulle.

D'une manière générale, la présente invention autorise un montage aisé d'un cristal entre les électrodes déposées sur un support distinct du cristal lui-même. En effet, le cristal 10 est engagé à la manière d'un tiroir dans la fente 31, par coulissement de sa partie périphérique sur les extrémités latérales de la face inférieure de l'ouverture 31. Les pointeaux 305, d'abord repoussés vers le haut contre l'action du ressort 303 par la tranche du cristal viennent ensuite s'encliqueter dans les trous 111 du cristal 10 pour verrouiller cilui-ci dans une position prédéterminée par rapport à l'ouverture 31, et donc par rapport aux électrodes 8 et 9. Le positionnement de la partie centrale active 101 du cristal ne dépend que de la hauteur de la fente 31 et de l'épaisseur du cristal 10. Le cristal 10 reste amovible par rapport au bloc 3 porteur d'électrodes, et le bloc 3 lui-même peut être facilement démonté, les arceaux 301 pouvant facilement être séparés du socle 1. Par suite, si l'on dispose d'un jeu de pastilles de cristal piézoélectrique de différentes épaisseurs et/ou si l'on dispose d'un jeu de blocs porteurs d'électrodes comprenant des ouvertures 31 de géométries différentes, il est possible de réaliser facilement des résonateurs de caractéristiques très différentes, ou d'ajuster les caractéristiques d'un résonateur, en ne combinant que deux pièces de base de caractéristiques variables, à savoir un ensemble monobloc 3 porteur d'électrodes et une pastille piézoélectrique 10.

Les figures 6 et 7 montrent deux exemples de configuration possible pour l'ouverture 31 du bloc 3 et le cristal piézoélectrique 10. Selon la figure 6, le cristal 10 est biplan et présente une épaisseur constante dans toute sa section, excepté éventuellement dans la zone intermédiaire qui peut être amincie. Le cristal 10 repose par une partie de sa zone périphérique 102 directement sur la face inférieure de l'ouverture 31, au voisinage des extrémités latérales 311, 312 de cette ouverture. Les pointeaux 305 engagés partiellement dans les petits trous 111 formés dans la partie périphérique 102 du cristal maintiennent ce dernier dans une position fixe par rapport au bloc 3. La distance entre la face inférieure de la partie centrale 101 du cristal et la partie d'électrode inférieure 90 déposée sur la face 319 de l'ouverture 31, est fixe et déterminée par la distance entre le niveau de la partie 319 de la face inférieure de l'ouverture 31 et le niveau de cette même face inférieure dans les zones latérales 311 et 312 supportant le cristal. La distance entre la face supérieure de la partie centrale 101 du cristal et la partie d'électrode supérieure 80 déposée sur la face 318 de l'ouverture 31 dépend de l'épaisseur du cristal 10. La fréquence de résonance du résonateur peut ainsi être modifiée en agissant sur l'épaisseur du cristal 10.

Dans le mode de réalisation de la figure 7, la face inférieure de l'ouverture 31 se trouve au même niveau dans les parties latérales 311, 312 et dans la partie centrale 319 supportant l'électrode 9. Les retraits 313, 314 formés dans des zones situées en regard de la partie intermédiaire du cristal pourraient ainsi à la limite être supprimés, bien qu'ils puissent faciliter la réalisation du dépôt de l'électrode 9 sur la partie 319 dans la mesure où ils forment une limite bien tranchée avec les portions 311, 312 qui sont en principe dépourvues d'électrodes. Dans le cas de la figure 7, le cristal 10 comporte une partie centrale 101 qui est en retrait par rapport à la partie périphérique 102 reposant sur la face inférieure de l'ouverture 31 dans les zones 311, 312. La distance entre la face inférieure de la partie centrale 101 du cristal et la partie d'électrode inférieure 90 disposée sur le bloc 3 est ainsi déterminée par la différence de niveau entre les faces inférieures de la bague périphérique 102 et de la partie centrale 101 du cristal. Un ajustement peut être réalisé par une action sur l'épaisseur de la partie périphérique 102 et par exemple par le choix d'un cristal parmi un lot de cristaux ayant des parties périphériques 102 de différentes épaisseurs.

Les électrodes 8 et 9 sont essentiellement déposées sur les faces internes 318, 319 de l'ouverture 31. Toutefois, pour faciliter la connexion des fils de liaison 6, 7 aux électrodes 8, 9, un dépôt métallique 81, 91 peut en outre être effectué dans le prolongement des électrodes 80, 90 proprement dites, sur les faces frontales du bloc 3, ainsi que sur la face supérieure du bloc 3 pour l'électrode 8, et sur la face inférieure du bloc 3 pour l'électrode 9 (figures 1, 2 et 8). On dispose ainsi, dans la partie centrale du bloc 3, d'un premier ruban métallique 8 entourant le bloc 3 dans sa portion située au-dessus de l'ouverture 31, et d'un deuxième ruban métallique 9 entourant le bloc 3 dans sa partie située au-dessous de l'ouverture 31, les rubans métalliques 8, 9 pouvant être par exemple en or.

Les figures 4 et 5 correspondent à des caractéristiques particulières d'un résonateur selon l'invention. Sur ces figures, on n'a représenté que le bloc 3. Dans le mode de réalisation de la figure 4, le bloc 3 comprend des prolongements 36, 37 entre lesquels prend appui une lame piézoélectrique supplémentaire 33 munie d'électrodes 34, 35. Les prolongements 36, 37 déterminent un logement 32 dans lequel est insérée la lame 33, et les prolongements 36, 37 peuvent être reliés au corps du bloc 3 par des parties légèrement amincies par des rainures telles que 38. Lorsqu'une tension électrique V est appliquée aux électrodes 34, 35, la lame piézoélectrique 32 se déforme. La lame 32 peut être une céramique piézoélectrique, ou par exemple, une coupe de quartz dont l'épaisseur e se trouve selon l'axe x et la longueur 1 interposée entre les prolongements 36, 37 du bloc 3 se trouve selon l'axe y du cristal dans lequel est fait la coupe. Sous l'action de la tension électrique V, la lame 32 se déforme en longueur et acquiert une longueur l + dl de sorte que les prolongements 36, 37 sont poussés vers l'extérieur et, par leur flexion, tendent à conférer à la face 318 de l'ouverture 31 une certaine concavité. L'espace libre compris entre l'électrode 8 déposée sur la face 318 du bloc 3 et la face correspondante de la partie centrale du cristal tend ainsi à s'accroître, et la fréquence du résonateur est modifiée. Cette modification peut être un changement de fréquence permanent, si la tension V appliquée aux électrodes 33, 34 est continue, ou une modulation de la fréquence de résonance moyenne du résonateur, si la tension V est alternative. L'espace libre entre l'électrode 9 et la face inférieure de la partie centrale 101 du cristal 10 pourrait de même être modifié ou modulé par l'adjonction de prolongements ou bras dans la partie inférieure du bloc 3, et la mise en place d'une lame piézoélectrique analogue à la lame 32 entre lesdits prolongements inférieurs. D'une manière générale, le résonateur selon l'invention peut d'ailleurs fonctionner dans n'importe quelle position, et les termes »inférieur«, »supérieur«, »vertical«, »horizontal« ne sont utilisés en référence au dessin que pour faciliter les explications. Ainsi, ce qui a été dit à propos de la face inférieure de l'ouverture 31 peut s'appliquer à la face supérieure de ladite ouverture et vice-versa.

La figure 5 représente un mode de réalisation de l'invention dans lequel plusieurs ouvertures 31, 31' du type décrit précédemment et destinées à être munies d'électrodes et à recevoir chacune un cristal piézoélectrique 10, sont superposées dans un même bloc diélectrique 3. Ceci constitue un dispositif très compact pouvant constituer un résonateur multiple. Chaque résonateur élémentaire constitué par une ouverture telle que 31 ou 31' équipée d'électrodes, non représentées, et par une pastille de cristal piézoélectrique telle que 10 insérée dans ladite ouverture peut fonctionner indépendamment de l'autre ou des autres résonateurs élémentaires. Les caractéristiques de chaque résonateur élémentaire sont déterminées par la forme et les dimensions de l'ouverture 31, 31', les caractéristiques des électrodes et de la tension électrique appliquée à celles-ci, et la forme et les dimensions de la pastille de cristal piézoélectrique 10. Le montage est extrêmement simple, puisque chaque cristal 10 peut être engagé dans un logement 31, 31' à la manière d'un tiroir de la manière expliquée plus haut. La figure 5 représente un bloc 3 de résonateur double muni de deux ouvertures semblables superposées 31, 31'. Les différentes parties de l'ouverture 31' sont désignées par des références primées par analogie avec les parties de l'ouverture 31. Dans le cas de la figure 5, l'électrode déposée sur la face 319' de l'ouverture 31' peut être connectée en permanence à l'électrode déposée sur la face 318 de l'ouverture 31 et le résonateur double peut fonctionner avec une interdépendance des deux sous-ensembles constitués par chacune des ouvertures 31, 31' munies d'électrodes et équipées d'un cristal correspondant, selon un montage du type série ou parallèle, de manière analogue aux montages décrits dans la demande de brevet français n° 7 828 728 déposée le 9 Octobre 1978 et intitulée »birésonateur piézoélectrique«.

Les résonateurs conformes à la présente invention sont notamment remarquables en ce que la configuration du bloc supportant les électrodes peut être sensiblement différente de la géométrie du cristal piézoélectrique. Ainsi, le cristal piézoélectrique 10 inséré dans l'ouverture 31 du bloc 3 peut s'étendre au-delà des faces frontales externes 41, 42 du bloc 3, comme représenté sur les figures 1 à 3. Toutefois, l'état de surface de la face dite inférieure de la partie périphérique 102 du cristal 10 et l'état de surface de la paroi de l'ouverture 31 destinée à coopérer directement avec cette face inférieure de la partie périphérique 102 du cristal sont particulièrement importants et doivent présenter un minimum d'aspérités.

Bien entendu, diverses modifications ou adjonctions peuvent être apportées par l'homme de l'art aux dispositifs qui viennent d'être décrits uniquement à titre d'exemples, sans sortir du cadre de protection de l'invention.

Ainsi, selon un mode de réalisation particulier, la partie active du cristal peut être constituée par la partie périphérique de celui-ci tandis que la partie d'immobilisation est dans ce cas constituée par la partie centrale du cristal. Ce mode de réalisation implique naturellement que les électrodes sont alors disposées sur le bloc support dans la partie de l'ouverture en forme de fente qui est située en regard de la partie périphérique du cristal et dans ce cas, sans contact avec cette dernière, tandis que le cristal est maintenu en place par des moyens de support qui agissent sur les parties centrales du bloc et du cristal, en contact par une de leurs faces à l'intérieur de l'ouverture ménagée dans le bloc support.

### Revendications

1. Résonateur piézoélectrique à électrodes non adhérentes au cristal, du type comprenant un boitier étanche (1, 2) dans lequel on a fait le vide ou introduit un gaz résiduel, à l'intérieur de ce boitier, au moins un cristal piézoélectrique (10) muni d'une partie périphérique (102) formant bague reliée à une partie centrale (101) par une zone intermédiaire (103 à 106) qui présente une faible longueur dans le sens radial, des électrodes (8, 9) disposées respectivement en regard de chacune des faces de la partie centrale du cristal, à faible distance de celles-ci, et des moyens de maintien des électrodes et du cristal dans des positions relatives prédéterminées à l'intérieur du boitier, caractérisé en ce que les moyens de maintien des électrodes et du cristal comprennent un bloc unitaire (3) en matériau diélectrique dans lequel est ménagée au moins une ouverture (31) qui présente une section supérieure à la section du cristal (10) pour permettre une insertion du cristal à travers ladite ouverture, en ce que les électrodes (8, 9) sont déposées sur le bloc diélectrique (3) dans la partie centrale respectivement des faces supérieure (318) et inférieure (319) de l'ouverture et en ce que le cristal est immobilisé dans ladite ouverture par sa partie périphérique de manière que la partie centrale du cristal reste située en regard des électrodes et sans contact avec celles-ci.

2. Résonateur selon la revendication 1, caractérisé en ce que le cristal piézoélectrique (10) repose par des portions de sa partie périphérique (102) directement sur la face inférieure de l'ouverture du bloc diélectrique dans des zones (311, 312) de ladite face inférieure qui sont adaptées à la forme de la partie périphérique du cristal.

3. Résonateur selon la revendication 2, caractérisé en ce que des moyens mécaniques de serrage (303 à 305) coopèrent avec la partie périphérique (102) du cristal pour maintenir des portions de cette partie périphérique en contact avec les dites zones de la face inférieure (319) de l'ouverture du bloc diélectrique.

4. Résonateur selon la revendication 3, caractérisé en ce que les moyens mécaniques de serrage sont constitués par des moyens de maintien élastiques tels que des ressorts.

5. Résonateur selon l'une quelconque des revendications 1 à 4, caractérisé en ce que la partie périphérique (311, 312) de la face inférieure de l'ouverture du bloc diélectrique est proéminente par rapport à la partie centrale de ladite face inférieure sur laquelle est déposée une électrode.

6. Résonateur selon l'une quelconque des revendications 1 à 5, caractérisé en ce que l'ouverture (31) du bloc diélectrique possède une section plus importante dans sa portion située au voisinage de la zone intermédiaire du cristal.

7. Résonateur selon l'une quelconque des revendications 1 à 6, caractérisé en ce que le cristal est monté dans le bloc diélectrique de manière amovible.

8. Résonateur selon l'une quelconque des revendications 3 à 7, caractérisé en ce que les moyens de serrage sont constitués par des pointeaux (304, 305) engagés et coulissants chacun dans un orifice ménagé dans la partie supérieure du bloc diélectrique, chaque pointeau coopérant avec un moyen de ressort (303) pour exercer une pression sur la partie périphérique du cristal et maintenir celle-ci en contact avec une zone périphérique de la face inférieure de l'ouverture de bloc diélectrique.

9. Résonateur selon la revendication 8, caractérisé en ce que les pointeaux peuvent s'engager au moins partiellement dans des trous (111) ménagés dans la partie périphérique du cristal pour assurer un verrouillage du cristal dans une position prédéterminée.

10. Résonateur selon l'une quelconque des revendications 4, 8 et 9, caractérisé en ce que le bloc diélectrique est maintenu à l'intérieur du boitier par des arceaux (301) fixés audit boitier et en ce que les moyens de ressort sont constitués par des lames-ressort coopérant avec les arceaux.

11. Résonateur selon l'une quelconque des revendications 1 à 10, caractérisé en ce que le bloc diélectrique est de forme parallélépipédique.

12. Résonateur selon l'une quelconque des revendications 1 à 11, caractérisé en ce que l'ouverture ménagée dans le bloc diélectrique présente la forme d'une fente de hauteur variable dont les faces inférieure et supérieure sont planes et parallèles au moins dans la partie supportant les électrodes.

13. Résonateur selon la revendication 12, caractérisé en ce que les électrodes sont de forme carrée.

14. Résonateur selon l'une quelconque des revendications 1 à 13, caractérisé en ce que l'ouverture ménagée dans le bloc diélectrique présente la forme d'une fente dont les petites faces latérales sont parallèles entre elles.

15. Résonateur selon l'une quelconque des revendications 1 à 14, caractérisé en ce que le cristal piézoélectrique inséré dans l'ouverture du bloc diélectrique s'étend au-delà des faces frontales externes dudit bloc.

16. Résonateur selon l'une quelconque des revendications 1 à 15, caractérisé en ce que le cristal piézoélectrique présente la forme d'un disque de diamètre légèrement inférieur à la largeur de l'ouverture en forme de fente ménagée dans le bloc diélectrique.

17. Résonateur selon la revendication 9, dans lequel le cristal comprend des évidements dans sa partie intermédiaire et présente de minces ponts de liaison (103 à 106) entre ses parties périphérique et centrale, caractérisé en ce que les trous (111) ménagés dans la partie périphérique du cristal sont situés dans des zones éloignées des ponts de liaison.

18. Résonateur selon l'une quelconque des revendications 1 à 17, caractérisé en ce que le bloc diélectrique comporte des prolongements (36, 37) entre lesquels prend appui une lame piézoélectrique supplémentaire (33) munie d'électrodes (34, 35) de manière à modifier dans le bloc diélectrique la distance entre les parties centrales des faces inférieure (319) et supérieure (318) de l'ouverture porteuses d'électrodes en fonction de la tension électrique appliquée aux électrodes de la lame piézoélectrique supplémentaire.

19. Résonateur selon l'une quelconque des revendications 1 à 17, caractérisé en ce que le bloc diélectrique comporte plusieurs ouvertures (31, 31') superposées minies d'électrodes et équipées chacune d'un cristal piézoélectrique pour former dans un bloc unique une pluralité de résonateurs.

20. Résonateur selon la revendication 19, caractérisé en ce que le bloc diélectrique comprend deux ouvertures semblables superposées équipées chacune d'un cristal piézoélectrique et en ce que les deux cristaux coopèrent avec au moins une électrode commune.

21. Résonateur piézoélectrique à électrodes non adhérentes au cristal, du type comprenant un boitier étanche dans lequel on a fait le vide ou introduit un gaz résiduel, à l'intérieur de ce boitier, au moins un cristal piézoélectrique muni d'une partie périphérique formant bague reliée à une partie centrale par une zone intermédiaire qui présente une faible longueur dans le sens radial, des électrodes disposées respectivement en regard de chacune des faces de l'une des parties centrale et périphérique de cristal, à faible distance de celles-ci, et des moyens de maintien des électrodes et du cristal dans des positions relatives prédéterminées à l'intérieur du boitier, caractérisé en ce que les moyens de maintien des électrodes et du cristal comprennent un bloc unitaire en matériau diélectrique dans lequel est ménagée au moins une ouverture qui présente une section supérieure à la section du cristal pour permettre une insertion du cristal à travers ladite ouverture, en ce que les électrodes son sont déposées sur le bloc diélectrique dans la partie périphérique respectivement des faces supérieure et inférieure de l'ouverture et en ce que le cristal est immobilisé dans ladite ouverture par sa partie centrale de manière que la partie périphérique du cristal reste située en regard des électrodes et sans contact avec celles-ci.

**Patentansprüche**

1. Piezoelektrischer Resonator mit nicht am Kristall anliegenden Elektroden, vom Typ der mit einem luftdichten Behälter aufgebaut ist (1, 2), in dem man entweder Leere geschaffen, oder ein übrigbleibendes Gas eingeführt hat. In diesem Behälter befindet sich mindestens ein Kristall (10), der mit einem äußeren Teil (102) bestückt ist, das einen Ring formt. Dieser ist an den zentralen Teil (101) durch eine Transitzone (103 bis 106), die eine kleine Abmessung im radialen Sinne besitzt, angeschlossen. Der Behälter enthält ebenfalls Elektroden (8, 9), die jeweils einer der Fassaden des zentralen Teiles des Kristalles sehr nahe gegenüberliegen. Der Behälter beherbergt außerdem die Halterung der Elektroden und des Kristalles, die sich in vorbestimmten Lagen in besagtem Behälter befinden.

Der Anspruch ist durch die Mittel charakterisiert, die die Halterung der Elektroden und des Kristalles betreffen, die einen einzigen Block (3) aus dielektrischem Material darstellen, in dem mindestens eine Öffnung (3) vorhanden ist, die eine größere Oberfläche als die des Kristalles besitzt (10), um die Eingliederung des Kristalles durch die Öffnung hindurch zu gestatten. Dazu kommt, daß die Elektroden (8, 9) auf dem dielektrischen Block (3) im Mittelteil je an der oberen Seite (318) und an der unteren Seite (319) der Öffnung angebracht sind und daß der Kristall in der besagten Öffnung durch seine Außenseite festgehalten wird, so daß der mittlere Teil des Kristalles den Elektroden gegenüber liegen bleibt, ohne jedoch diese Elektroden zu berühren.

2. Resonator gemäß Anspruch 1, charakterisiert durch die Tatsache, daß der piezoelektrische Kristall (10) mit Portionen seiner Peripherie (102) direkt auf der unteren Seite der Öffnung im dielektrischen Block in den Zonen 311 und 312 aufliegt. Die genannten Zonen der unteren Seite sind der Umfangsform (Peripherie) des Kristalles angepaßt.

3. Resonator gemäß Anspruch 2, charakterisiert durch die Tatsache, daß mechanische Verknüpfungsmittel die Peripherie des Kristalles unterstützen, um die Teile der Peripherie, die mit den besagten Zonen der unteren Seite (319) der Öffnung im dielektrischen Block in Berührung sind, zusammen zu halten.

4. Resonator gemäß Anspruch 3, charakterisiert durch die Tatsache, daß die mechanischen Verknüpfungsmittel durch elastische Materialien, wie zum Beispiel Federn, ersetzt sind.

5. Resonator gemäß irgendeinem der Ansprüche 1 bis 4, charakterisiert durch die Tatsache, daß der Peripherieteil der unteren Seite der Öffnung im dielektrischen Block dem zentralen Teil der genannten unteren Seite, auf der eine Elektrode deponiert ist, gegenüber erhaben ist (vorherragt).

6. Resonator gemäß einem der Ansprüche 1 bis 5, charakterisiert durch die Tatsache, daß die Öffnung (31) des dielektrischen Blocks in dem Teil, der der Zwischenzone des Kristalles nahe liegt, eine größere Stärke besitzt.

7. Resonator gemäß einem der Ansprüche 1 bis 6, charakterisiert durch den Umstand, daß der Kristall auswechselbar im dielektrischen Block montiert ist.

8. Resonator gemäß irgendeinem der Ansprüche 3 bis 7, charakterisiert durch die Tatsache, daß die Verknüpfungsmittel aus Spitzkeilen (304 und 305) bestehen, die jeder in ein, in der oberen Seite des dielektrischen Blocks vorgesehenes Loch, gleitend eingeführt sind.

Jeder dieser Spitzkeile arbeitet mit einer Feder, die gestattet auf die Peripherie des Kristalles einen gewissen Druck auszuüben, und somit den Kristall mit seiner unteren Peripherie auf die untere Seite der Öffnung im dielektrischen Block zu drücken.

9. Resonator gemäß Anspruch 8, charakterisiert durch die Tatsache, daß die Spitzkeile teilweise in an der Peripherie des Kristalles vorgesehene Löcher eingreifen, um eine Verriegelung des Kristalles in einer vorbestimmten Lage zu erreichen.

10. Resonator gemäß irgendeinem der Ansprüche 4, 8 und 9, charakterisiert durch die Tatsache, daß der dielektrische Block im Behälter durch Bögen (301) gehalten wird, die im besagten Behälter befestigt sind, und daß die Mittel zur Federung aus Federplättchen bestehen, die mit den Bögen zusammenarbeiten.

11. Resonator gemäß irgendeiner der Ansprüche 1 bis 10, charakterisiert durch die parallelopedische Form des dielektrischen Blocks.

12. Resonator gemäß irgendeinem der Ansprüche 1 bis 11, charakterisiert durch die Tatsache, daß sich die im dielektrischen Block befindliche Öffnung in der Form einer Spalte mit veränderlicher Höhe vorstellt. Die obere und untere Seite der Spalte sind eben und parallel, auf jeden Fall in der Zone wo sie die Elektroden halten.

13. Resonator gemäß Anspruch 12, charakterisiert durch die rechteckige Form der Elektroden.

14. Resonator gemäß irgendeinem der Ansprüche 1 bis 13, charakterisiert durch die Tatsache, daß sich die im dielektrischen Block befindliche Öffnung in Form einer Spalte vorstellt, deren kleine Seiten untereinander parallel sind.

15. Resonator gemäß irgendeinem der Ansprüche 1 bis 14, charakterisiert durch die Tatsache, daß sich der piezoelektrische Kristall, in der Öffnung des dielektrischen Blocks, über die Grenzen der Vorderfläche besagten Blocks erstreckt.

16. Resonator gemäß irgendeinem der Ansprüche 1 bis 15, charakterisiert durch die Tatsache, daß sich der piezoelektrische Kristall in Form einer Scheibe vorstellt, deren Durchmesser ein wenig kleiner ist als die Breite der spaltförmigen Öffnung im dielektrischen Block.

17. Resonator gemäß Anspruch 9, wobei der Kristall Kerben an seinem Zwischenteil besitzt, und schmale Verbindungsbrücken (103 bis 106) zwischen seinen Peripherie- und Zentralteilen aufweist, charakterisiert durch die Tatsache, daß sich die am Peripherieteil des Kristalles vorgehenden Löcher (11) in Zonen, die von den Verbindungsbrücken entfernt liegen, befinden.

18. Resonator gemäß irgendeinem der Ansprüche 1 bis 17, charakterisiert durch einen dielektrischen Block der Verlängerungen (36, 37) besitzt, zwischen denen ein zusätzliches piezoelektrisches Plättchen (33) aufliegt. Es ist mit Elektroden versehen, um die Entfernung zwischen den zentralen Teilen der unteren (319) und oberen (318) Fläche der Öffnung im dielektrischen Block, die die Elektroden beherbergt, zu verändern. Diese Änderung ist Funktion der an das zusätzliche piezoelektrische Plättchen angelegten elektrischen Spannung.

19. Resonator gemäß irgendeinem der Ansprüche 1 bis 17, charakterisiert durch die Tatsache, daß der dielektrische Block mehrere Öffnungen besitzt (31, 31'). Sie liegen übereinander, sind mit Elektroden ausgestattet, und sind jeweils mit einem Kristall bestückt, um schließlich in einem einzigen Block eine Mehrzahl von Resonatoren zu ermöglichen.

20. Resonator gemäß Anspruch 19, charakterisiert durch einen dielektrischen Block mit zwei gleichen, übereinander liegenden Öffnungen, jede mit einem piezoelektrischen Kristall bestückt, die eine gemeinsame Elektrode besitzen.

21. Piezoelektrischer Resonator mit nicht am Kristall anliegenden Elektroden, vom Typ der mit einem luftdichten Behälter aufgebaut ist (1, 2), in dem man entweder Leere geschaffen, oder ein übrigbleibendes Gas eingeführt hat. In diesem Behälter befindet sich mindestens ein Kristall (10), der mit einem äußeren Teil (102) bestückt ist, das einen Ring formt. Dieser ist an den zentralen Teil (101) durch eine Transitzone (103 bis 106), die eine kleine Abmessung im radialen Sinne besitzt, angeschlossen. Der Behälter enthält ebenfalls Elektroden (8, 9), die jeweils einer der Fassaden des Peripherie- oder Zentralteiles des Kristalles sehr nahe gegenüber liegen. Der Behälter beherbergt außerdem die Halterung der Elektroden und des Kristalles, die sich in vorbestimmten Lagen in besagtem Behälter befinden.

Der Anspruch ist durch die Mittel charakterisiert, die die Halterung der Elektroden und des Kristalles betreffen, die einen einzigen Block (3) aus dielektrischem Material darstellen, in dem mindestens eine Öffnung (31) vorhanden ist, die eine größere Oberfläche als die des Kristalles besitzt (10), um die Eingliederung des Kristalles durch die Öffnung hindurch zu gestatten. Dazu kommt, daß die Elektroden (8, 9) auf dem dielektrischen Block im Peripherieteil je an der oberen und unteren Seite der Öffnung angebracht sind, und daß der Kristall in der besagten Öffnung durch seinen Mittelteil festgehalten wird, so daß der Peripherieteil des Kristalles den Elektroden gegenüber liegen bleibt, ohne jedoch diese Elektroden zu berühren.

## Claims

1. A piezoelectric resonator with electrodes not adhering to the crystal, of the type comprising an airtight casing (1,2) in which a vacuum has been created or an inert gas introduced, and inside this casing, at least one piezoelectric crystal (10) provided with a peripheral part (102) forming a ring connected to a central part (101) by an intermediate zone (103 to 106 which has a short length in the radial direction, electrodes (8, 9) placed respectively opposite each of the faces of the central part of the crystal, at a small distance from these, and means formaintaining the electrodes and crystal in predetermined relative positions inside the casing, characterised in that the means for maintaining the electrodes and crystal in position comprise a single unit (3) of dielectric matérial in which is made at least one opening (31) which has a section greater than the section of the crystal (10) to enable the crystal to be inserted through said opening, and in that the electrodes (8, 9) are deposited on the dielectric unit (3) in the central part respectively of the upper (318) and lower (319) faces of the opening, and in that the crystal is fixed in said opening by its peripheral part in a manner such that the central part of the crystal remains located opposite the electrodes and spaced apart therefrom.

2. Resonator according to claim 1, characterised in that the piezoelectric crystal (10) rests by portions of its peripheral part (102) directly on the lower face of the opening of the dielectric unit in zone (311, 312) of said lower face which are in the shape of the peripheral part of the crystal.

3. A resonator according to claim 2, characterised in that mechanical means of tightning (303 to 305) cooperate with the peripheral part (102) of the crystal to maintain portions of this peripheral part in contact with said zones of the lower face (319) of the opening of the dielectric unit.

4. A resonator according to claim 3, characterised in that the mechanical means of tightning are constituted by elastic holding means such as springs.

5. A resonator according to any one of claims 1 to 4, characterised in that the peripheral part (311, 312) of the lower face of the opening of the dielectric unit projects with respect to the central part of said lower face in which an electrode is deposited.

6. A resonator according any one of claims 1 to 5, characterised in that the opening (31) of the dielectric unit has a larger section located in its portion located close to the intermediate zone of the crystal.

7. A resonator according to any one of claims 1 to 6, characterised in that the crystal is mounted removably in the dielectric unit.

8. A resonator according to any one of claims 3 to 7, characterised in that the means for tightning are constituted by needles (304, 305) each engaging and sliding in an orifice made in the upper part of the dielectric unit, each needle cooperating with a spring means (303) to exert a pressure on the peripheral part of the crystal and maintain the latter in contact with the peripheral zone of the lower face of the opening of the dielectric unit.

9. A resonator according to claim 8, characterised in that the needles engage at least partially in the holes (111) made in the peripheral part of the crystal in oder to lock the crystal in a predetermined position.

10. A resonator according to any one of claims 4, 8 and 9, characterised in that the dielectric unit is maintained inside the casing by hoops (301) fixed to said casing and in that the spring means are constituted by leaf springs cooperating with the hoops.

11. A resonator according any one of claims 1 to 10, characterised in that the dielectric unit is of a parallelipipedal form.

12. A resonator according to any one of claims 1 to 11, characterised in that the opening made in the dielectric unit thas the shape of of a slit of variable height of which the lower and upper faces are plane and parallel at least in the part supporting the electrodes.

13. A resonator according to claim 12, characterised in that the electrodes are of shape.

14. A resonator according to any one of claims 1 to 13, characterised in that the opening made in the dielectric unit has the shape of a slit of which the small lateral faces are parallel to one another.

15. A resonator according to any one of claims 1 to 14, characterised in that the piezoelectric crystal inserted in the opening of the diélectric unit extends beyond the front external faces of said unit.

16. A resonator according to any one of claims 1 to 15, charactérised in that the piezoelectric crystal has the shape of a disc of a diameter slightly smaller than the width of the opening in the shape of a slit made in the dielectric unit.

17. A resonator according to claim 9, in which the crystal comprises hollow portions in its intermédiate part and has thin connecting bridges (103 to 106) between ist peripheral and central parts, characterised in that the holes (111) made in the peripheral part of the crystal are located in zones away from the connecting bridges.

18. A resonator according to any one of claims 1 to 17, characterised in that dielectric unit comprises extensions (36, 37) between which rests an additional piezoelectric crystal provided with electrodes (34, 35) in a manner such as to modify in the electric unit the distance between the central parts of the lower (319) and upper (318) faces of the opening carrying the electrode in accordance with the electric voltage applied to the electrodes of the additional piezoelectric crystal.

19. A resonateur according to any one of claims 1 to 17, characterised in that the dielectric unit comprises a plurality of superimposed openings (31, 31') provided with electrodes and each fitted with a piezoelectric crystal to form a plurality of resonators in a single unit.

20. A resonator according to claim 19, characterised in that the dielectric unit comprises two superimposed similar openings each fitted with apiezoelectric crystal and in the two crystale cooperate with at least one common electrode.

21. A piezoelectric resonator with electrodes not adhering to the crystal, of the type comprising an airtight casing in which a vacuum has been created or an inert gas introduced, and inside the casing, at least one piezoelectric crystal provided with a peripheral part forming a ring connected to a central part by an intermediate zone which has a short length in the radial direction, electrodes placed respectively opposite each of the faces one of the central and peripheral parts of the crystal, at a small distance from these, and means for maintaining the electrodes and crystal in predertermined relative positions inside the casing, characterised in that the means for maintaining the electrodes ans crystal in position comprise a single unit of dielectric material in which is made at least one opening which has a greater section than the section of the crystal to enable the crystal to be inserted through said opening, and in that the electrodes are deposited on the peripheral part respectively of the upper and lower faces of the opening and in that the crystal is fixed in said opening by its central part in a manner such that the peripheral part of the crystal remains located opposite the electrodes without contacting said electrodes.

Fig. 1

Fig. 2

Fig. 3

Fig. 4

Fig. 5

Fig. 6

Fig. 7

Fig. 8